# EUROPEAN PATENT APPLICATION

(11) **EP 2 571 047 A2**
(43) Date of publication of application: **20.03.2013**
(21) Application number: 11795137.6
(22) Date of filing: 03.06.2011
(51) Int. Cl.: H01L 23/04, H01L 23/043

(54) **INSULATING RING FOR PACKAGING, INSULATING RING ASSEMBLY AND PACKAGE**

(71) Applicant: Huawei Technologies Co., Ltd., Shenzhen, Guangdong 518129 (CN)
(72) Inventor: WEI, Xiang, Guangdong 518129 (CN); XIE, Lunchen, Guangdong 518129 (CN)
(86) International application number: PCT/CN2011/075288
(87) International publication number: WO 2011/157171

(57) **Abstract**

Embodiments of the present invention provide an insulating ring for packaging, an insulating ring assembly and a package. A through hole of the insulating ring drills through a top surface and a bottom surface of the insulating ring, to accommodate a chip. An outer sidewall of the insulating ring has an outward extending protrusion. A side surface of the protrusion which faces the top surface is lower than the top surface. A pin is disposed on the side surface, and an adhesive material layer and a surface metallization layer in the pin are lower than the top surface. Therefore, silver ions in the adhesive material cannot pass around the outer sidewall and the top surface above the side surface to enter the package, thereby ensuring the reliability of a power amplifier (PA) device.

## Description

### FIELD OF THE INVENTION

The present invention relates to the field of chip packaging technologies, and in particular, to an insulating ring for packaging, an insulating ring assembly and a package.

### BACKGROUND OF THE INVENTION

A power amplifier (PA) generally has three packaging structures: ceramic packaging, plastic packaging and hybrid module packaging.

A package of the PA formed by the ceramic packaging includes a conductive flange at the bottom, a ceramic ring fixed on the conductive flange, a ceramic cap adhered to the ceramic ring through epoxy resin, and a pin sandwiched between the ceramic cap and the ceramic ring. Moisture in the external environment may penetrate through the epoxy resin to enter the package. When temperature changes rapidly in a temperature cycling stage, the moisture is condensed on the ceramic surface inside the package. Because an adhesive material used by an existing pin is usually CuAg alloy, and Ag in the adhesive material of an input end and an output end is not wrapped completely, Ag is dissolved to form silver ions. The silver ions migrate to the flange under the effect of an electric field (the direction of the electric field is from a gate of the input end to the flange and from a gate of the output end to the flange), and electrons are finally obtained at the flange and are reduced to metal silver. Upper and lower surfaces of the ceramic ring are electrically connected, thereby causing short circuit failure of the PA.

To solve the above problem, edges of end surfaces of an adhesive material layer and a pin layer of the pin are aligned with edges of an inner wall of the ceramic ring, and the end surfaces of the pin layer and the adhesive material layer are covered with a protective coating on the surface of the pin, thereby protecting the silver in the adhesive material from migrating.

In the implementation of the present invention, the inventor finds that the prior art at least has the following problems:

The end surfaces of the adhesive material layer and the pin layer are coplanar with the inner wall of the ceramic ring and the edges thereof are aligned. The direction from the pin layer and the adhesive material layer to the inner wall of the ceramic ring is parallel to the direction of the electric field. When a gap exists in the protective coating and the adhesive material is exposed, the above coplanar and edge-aligned construction provides a migration channel for leaked silver ions, thereby leading to the short circuit failure of the PA.

### SUMMARY OF THE INVENTION

Embodiments of the present invention provide an insulating ring for packaging, an insulating ring assembly and a package, so as to solve the problem of PA failure resulting from silver migration, on the basis of using a CuAg alloy adhesive material.

An embodiment of the present invention provides an insulating ring for packaging. A through hole of the insulating ring drills through a top surface and a bottom surface of the insulating ring, to accommodate a chip. An outer sidewall of the insulating ring has an outward extending protrusion at a position where a pin is connected. A side surface of the protrusion which faces the top surface is lower than the top surface. The pin is disposed on the side surface, and an adhesive material layer and a surface metallization layer in the pin are lower than the top surface.

An embodiment of the present invention further provides an insulating ring assembly. The insulating ring assembly includes an insulating ring and a pin connected to the insulating ring. A through hole of the insulating ring drills through a top surface and a bottom surface of the insulating ring, to accommodate a chip. An outer sidewall of the insulating ring has an outward extending protrusion at a position where the pin is connected. A side surface of the protrusion which faces the top surface is lower than the top surface. The pin is disposed on the side surface, and an adhesive material layer and a surface metallization layer in the pin are lower than the top surface. Exposed portions of each of other layers in the pin and the top surface adjacent to the pin are wrapped by a protective layer in the pin.

An embodiment of the present invention further provides a package. The package includes a conductive flange, an insulating ring fixed on the conductive flange, a pin connected to the insulating ring, and a seal cap covering the insulating ring. A through hole of the insulating ring drills through a top surface and a bottom surface of the insulating ring, and a space is formed by the through hole, the conductive flange and the seal cap to accommodate a chip. An outer sidewall of the insulating ring has an outward extending protrusion at a position where the pin is connected. A side surface of the protrusion which faces the top surface is lower than the top surface. The pin is disposed on the side surface, and an adhesive material layer and a surface metallization layer in the pin are lower than the top surface. Exposed portions of each of other layers in the pin and the top surface adjacent to the pin are wrapped by a protective layer in the pin.

For the insulating ring, the insulating ring assembly and the package in the embodiments of the present invention, because the side surface of the insulating ring where the pin is disposed is lower than the top surface, and the adhesive material layer and the surface metallization layer in the pin are lower than the top surface, the adhesive material after creeping also cannot be higher than the top surface. During the process of using a device, silver ions have no components of an electric field in a horizontal direction, and lateral migration is blocked by the outer sidewall which is above the side surface. The electric field directs to the side surface in a vertical direction and is opposite to the migration path of the silver ions. Therefore, the silver ions cannot pass around the outer sidewall and the top surface above the side surface to enter the package, and accordingly, the top surface and the bottom surface of the insulating ring cannot be electrically connected, thereby ensuring the reliability of a PA device.

### BRIEF DESCRIPTION OF THE DRAWINGS

FIG. 1 is a schematic three-dimensional view of Embodiment 1 of an insulating ring according to the present invention;

FIG. 2 is a schematic top view of Embodiment 1 of the insulating ring according to the present invention;

FIG. 3 is a schematic three-dimensional view of Embodiment 2 of the insulating ring according to the present invention;

FIG. 4 is a schematic top view of Embodiment 2 of the insulating ring according to the present invention;

FIG. 5 is a schematic three-dimensional view of Embodiment 3 of the insulating ring according to the present invention;

FIG. 6 is a schematic top view of Embodiment 3 of the insulating ring according to the present invention;

FIG. 7 is a schematic three-dimensional view of Embodiment 4 of the insulating ring according to the present invention;

FIG. 8 is a schematic sectional view along Line A-A in FIG. 2;

FIG. 9 is a schematic three-dimensional view of an insulating ring assembly according to an embodiment of the present invention; and

FIG. 10 is a schematic three-dimensional exploded view of a package according to an embodiment of the present invention.

### DETAILED DESCRIPTION OF THE EMBODIMENTS

To make the above objective, features, and advantages of the present invention more comprehensible, the present invention is hereinafter described in detail with reference to the accompanying drawings and exemplary embodiments.

The inventor analyzes the forming principle of silver migration in a PA, and improves the structure of an insulating ring from a conductive path by which the silver migration is cut off.

### Embodiment 1

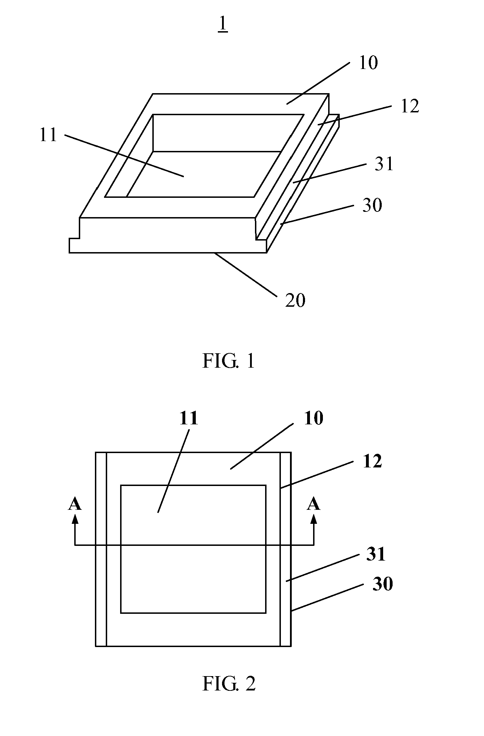

The embodiment provides an insulating ring for packaging. Referring to FIG. 1, a through hole 11 of the insulating ring drills through a top surface 10 and a bottom surface 20 of the insulating ring, to accommodate a chip (not shown).

An outer sidewall of the insulating ring 1 has an outward extending protrusion 30 at a position where a pin is connected. A side surface 31 of the protrusion 30 which faces the top surface 10 is lower than the top surface 10. The pin (not shown) is disposed on the side surface 31, and an adhesive material layer and a surface metallization layer in the pin (not shown) are lower than the top surface 10.

That the adhesive material layer and the surface metallization layer are lower than the top surface 10 may include two situations:

1. The surface metallization layer is only laid on the side surface 31 while the adhesive material layer is laid on the surface metallization layer. An upper surface of the adhesive material layer is lower than the top surface 10.

Because the pin is adhered to the insulating ring through an adhesive material, the surface of the insulating ring to which the pin is adhered needs to be processed firstly, that is, to form the surface metallization layer; therefore, without the surface metallization layer, the adhesion between the adhesive material and the insulating ring is insecure.

In this case, the upper surface of the adhesive material is not higher than the top surface, and under the limitation of the surface metallization layer, the creeping of the adhesive material is limited to a horizontal direction.

2. The surface metallization layer is laid on the side surface 31 and partially covers the outer sidewall 12 that is above the side surface 31, and the maximum height of the surface metallization layer on the outer sidewall 12 is lower than the top surface 10. The adhesive material layer is laid on the surface metallization layer, and the maximum height of the adhesive material layer on the outer sidewall 12 is lower than the top surface 10.

Even though after a device is used for a period of time, the adhesive material creeps along the surface metallization layer, because the maximum height of the surface metallization layer is lower than the top surface 10, the final height of the adhesive material may not be higher than the top surface 10.

For the insulating ring of the above structure, a migration path for silver ions that may cause short circuit of the device is that the silver ions reach the top surface 10 from the adhesive material along the outer sidewall 12 that is above the side surface 31 and migrate to the through hole 11 of the insulating ring along the top surface 10, and then, owing to the effect of an electric field, the silver ions lead to conduction between the top surface 10 and the bottom surface 20 of the insulating ring, thereby causing the short circuit of the device.

Because the side surface 31 where the pin is disposed is lower than the top surface 10, the adhesive material layer and the surface metallization layer in the pin are lower than the top surface. Although the adhesive material can creep along the surface metallization layer, if the adhesive material has already crept along the surface metallization layer after the device is used for a period of time, because the surface metallization layer and the adhesive material layer are both lower than the top surface 10, the adhesive material after creeping also cannot be higher than the top surface. The migration of the silver ions in the adhesive material is free from the limitation of the adhesive material, but during the process of using the device, the silver ions have no components of the electric field in a horizontal direction, and lateral migration is blocked by the outer sidewall 12 that is above the side surface 31. The electric field directs to the side surface 31 in a vertical direction and is opposite to the foregoing migration path of the silver ions. Therefore, the silver ions cannot pass around the outer sidewall 12 and the top surface 10 above the side surface 31 to enter the package, and accordingly, the top surface and the bottom surface of the insulating ring cannot be electrically connected, thereby ensuring the reliability of a PA device.

The side surface 31 may be parallel to the top surface 10, and may also form an angle with the top surface 31, as long as the side surface 31 can be adhered to the pin. The upper surface and other side surfaces of the protrusion 30, which have no direct effect on the adhesion of the pin, are not limited by the embodiment of the present invention.

The insulating ring 1 may be a square insulating ring, and may also be a circular insulating ring and so on, which may be specifically determined according to the shape of a metal frame.

When the insulating ring 1 is the square insulating ring, as shown in FIG. 1 and FIG. 2, the protrusion 30 may extend to two ends of a square side where the protrusion 30 is located along a length direction of the square side. The side surface 31 may be maintained at a same height, and because such an insulating ring has a few sides, it is less difficult to process.

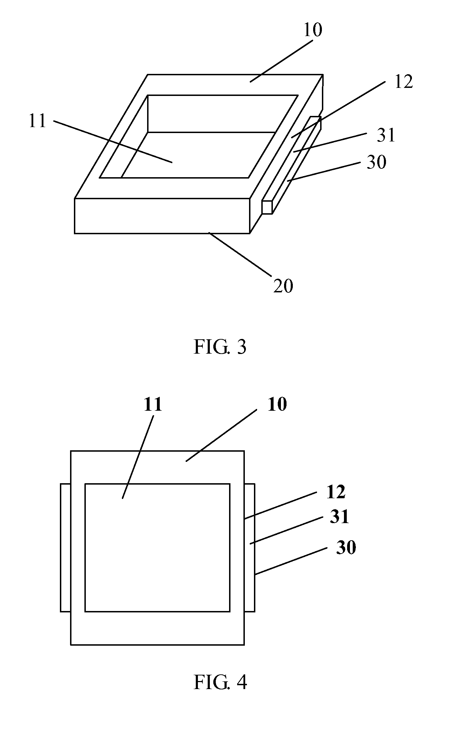

Definitely, the insulating ring may also be in a shape as shown in FIG. 3 and FIG. 4. The protrusion 30 extends along a length direction of a square side where the protrusion 30 is located, and the length of the protrusion 30 along the length direction of the square side where the protrusion 30 is located is less than the length of the square side. One end of the protrusion 30 along the length direction of the square side where the protrusion 30 is located may be aligned with one end of the square side where the protrusion 30 is located; and it may also be as shown in FIG. 3 that, two ends of the protrusion 30 along the length direction of the square side where the protrusion 30 is located are both positioned within two ends of the square side where the protrusion 30 is located. The above two cases both have no impact on the connection of the pin.

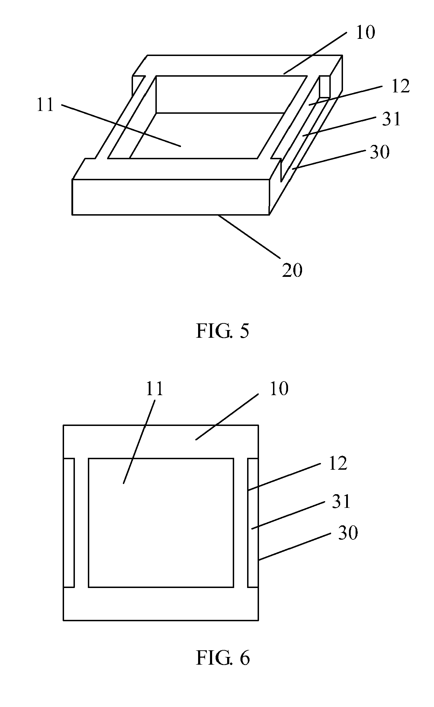

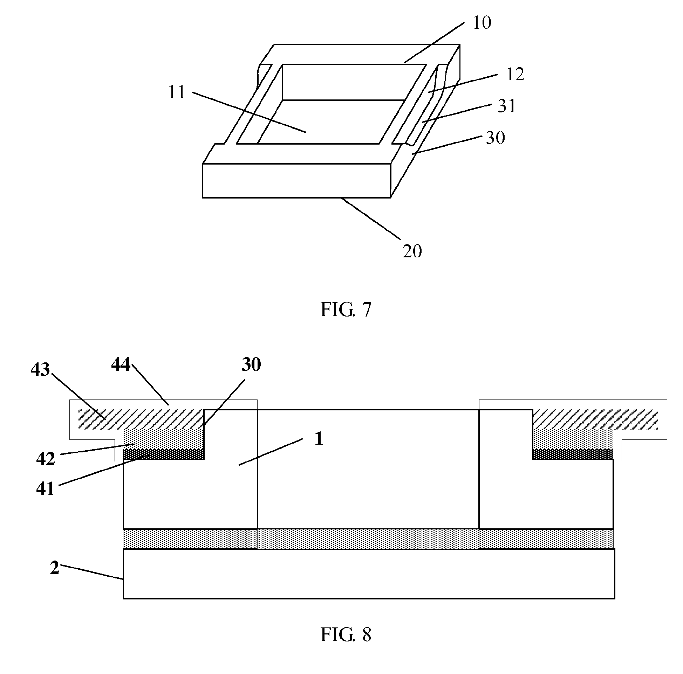

As shown in FIG. 5 and FIG. 6, the protrusion 30 of the insulating ring may further extend along a length direction of a square side where the protrusion 30 is located, and is connected with the top surface 10 at positions of two ends along the length direction of the square side where the protrusion 30 is located. The protrusion 30 provides the side surface 31 at a position where the pin is connected, and the two ends of the protrusion 30 in the length direction extend towards the top surface 10 and are finally connected with the top surface 10. The protrusion 30 may approach to the top surface in a smooth and gradual transition manner (referring to FIG. 7), or in a stepped and abrupt transition manner (referring to FIG. 5), which both have no impact on the connection of the pin.

The insulating ring 1 may be a ceramic ring, for example, the material may be aluminum oxide, and the insulating ring 1 may also be a plastic ring. The insulating ring may be processed by stamping, so that the insulating ring of the embodiment may be fabricated as along as a stamping die is modified, thereby causing a small impact on the cost of production.

Referring to FIG. 8, the pin is disposed on the side surface 31 and attached to the outer sidewall that is above the side surface 31. The pin includes the surface metallization layer 41, the adhesive material layer 42, a pin layer 43 and a protective layer 44 that wraps exposed portions of the surface metallization layer 41, the adhesive material layer 42 and the pin layer 43. The adhesive material layer 42 made of CuAg alloy is generally 15 to 20 µm in thickness, the surface metallization layer 41 (the material thereof may be W) between the adhesive material layer 42 and the insulating ring 1 is generally 15 to 20 µm in thickness, the pin layer 43 (the material thereof may be FeNi alloy) is generally about 100 µm in thickness, and an upper surface of the pin layer 43 is basically at the same level with the top surface 10, therefore, a distance between the side surface 31 and the top surface 10 is 130 to 140 µm, and the insulating ring 1 is generally greater than 200 µm in height.

Then, the protective layer 44 is electroplated at the exposed portions of the surface metallization layer 41, the adhesive material layer 42 and the pin layer 43 and the top surface 10 adjacent to the pin. The protective layer 44 may be made of NiCo alloy with good conductivity and is generally less than 3 µm in thickness.

For the insulating ring of the embodiment, because the side surface where the pin is disposed is lower than the top surface, and the adhesive material layer and the surface metallization layer in the pin are lower than the top surface, the adhesive material after creeping also cannot be higher than the top surface. During the process of using the device, the silver ions have no components of the electric field in the horizontal direction, and lateral migration is blocked by the outer sidewall that is above the side surface. The electric field directs to the side surface in the vertical direction and is opposite to the migration path of the silver ions. Therefore, the silver ions cannot pass around the outer sidewall and the top surface above the side surface to enter the package, and accordingly, the top surface and the bottom surface of the insulating ring cannot be electrically connected, thereby ensuring the reliability of the PA device.

Besides the PA device, the insulating ring may also be used for the packaging of PCBs (printed circuit boards) of other chips and hybrid chips, and so on. In addition to ceramic packaging, the foregoing insulating ring is also applicable to plastic packaging and hybrid module packaging, and so on.

### Embodiment 2

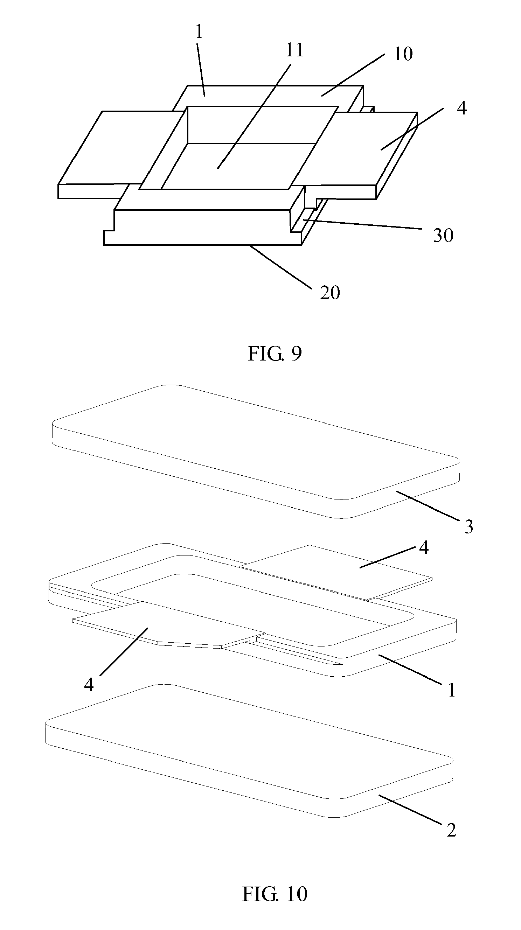

The embodiment provides an insulating ring assembly. As shown in FIG. 9, the insulating ring assembly includes an insulating ring 1 and a pin 4 connected to the insulating ring 1. A through hole 11 of the insulating ring 1 drills through a top surface 10 and a bottom surface 20 of the insulating ring 1, to accommodate a chip (not shown).

An outer sidewall of the insulating ring 1 has an outward extending protrusion 30 at a position where the pin 4 is connected. A side surface of the protrusion 30 which faces the top surface 10 is lower than the top surface 10. The pin 4 is disposed on the side surface, and an adhesive material layer and a surface metallization layer in the pin 4 are lower than the top surface 10. Exposed portions of each of other layers in the pin and the top surface 10 adjacent to the pin 4 are wrapped by a protective layer in the pin 4.

The insulating ring 1 may be a square insulating ring, and may also be a circular insulating ring and so on, which may be specifically determined according to the shape of a metal frame.

When the insulating ring 1 is the square insulating ring, the protrusion 30 may extend to two ends of a square side where the protrusion 30 is located along a length direction of the square side; the protrusion 30 may also extend along the length direction of the square side where the protrusion 30 is located, and the length of the protrusion 30 along the length direction of the square side where the protrusion 30 is located is less than the length of the square side; and the protrusion 30 may also extend along the length direction of the square side where the protrusion 30 is located, and is connected with the top surface at positions of two ends along the length direction of the square side where the protrusion 30 is located.

The insulating ring 1 may be a ceramic ring, for example, the material may be aluminum oxide, and the insulating ring may also be a plastic ring. The insulating ring may be processed by stamping, so that the insulating ring of the embodiment may be fabricated as along as a stamping die is modified, thereby causing a small impact on the cost of production.

The pin 4 is disposed on the side surface and attached to the outer sidewall that is above the side surface. The pin 4 includes the surface metallization layer, the adhesive material layer, a pin layer and the protective layer that wraps the exposed portions of the surface metallization layer, the adhesive material layer and the pin layer. The adhesive material layer made of CuAg alloy is generally 15 to 20 µm in thickness, the surface metallization layer (the material thereof may be W) between the adhesive material layer and the insulating ring 1 is generally 15 to 20 µm in thickness, the pin layer (the material thereof may be FeNi alloy) is generally about 100 µm in thickness, and an upper surface of the pin layer is basically at the same level with the top surface, therefore, a distance between the side surface and the top surface is 130 to 140 µm, and the insulating ring 1 is generally greater than 200 µm in height.

Then, the protective layer is electroplated at the exposed portions of the surface metallization layer, the adhesive material layer and the pin layer and the top surface adjacent to the pin 4. The protective layer may be made of NiCo alloy with good conductivity and is generally less than 3 µm in thickness.

For the insulating ring assembly of the embodiment, because the side surface of the insulating ring where the pin is disposed is lower than the top surface, and the adhesive material layer and the surface metallization layer in the pin are lower than the top surface, the adhesive material after creeping also cannot be higher than the top surface. During the process of using a device, silver ions have no components of an electric field in a horizontal direction, and lateral migration is blocked by the outer sidewall that is above the side surface. The electric field directs to the side surface in a vertical direction and is opposite to the migration path of the silver ions. Therefore, the silver ions cannot pass around the outer sidewall and the top surface above the side surface to enter the package, and accordingly, the top surface and the bottom surface of the insulating cannot be electrically connected, thereby ensuring the reliability of a PA device.

### Embodiment 3

The embodiment provides a package. Referring to FIG. 8 and FIG. 10 simultaneously, the package includes a conductive flange 2, an insulating ring 1 fixed on the conductive flange 2, a pin 4 connected to the insulating ring 1 and a seal cap 3 covering the insulating ring 1. A through hole of the insulating ring 1 drills through a top surface and a bottom surface of the insulating ring 1. A space is formed by the through hole, the conductive flange 2 and the seal cap 3 to accommodate a chip.

An outer sidewall of the insulating ring 1 has an outward extending protrusion at a position where the pin 4 is connected. A side surface of the protrusion which faces the top surface is lower than the top surface. The pin 4 is disposed on the side surface, and an adhesive material layer and a surface metallization layer in the pin are lower than the top surface. Exposed portions of each of other layers in the pin 4 and the top surface adjacent to the pin are wrapped by a protective layer in the pin 4.

The insulating ring 1 may be a square insulating ring as shown in FIG. 9, and may also be a circular insulating ring and so on, which may be specifically determined according to the shape of a metal frame.

When the insulating ring 1 is the square insulating ring, the protrusion may extend to two ends of a square side of the insulating ring where the protrusion is located along a length direction of the square side; the protrusion may also extend along the length direction of the square side of the insulating ring where the protrusion is located, and the length of the protrusion along the length direction of the square side is less than the length of the square side; and the protrusion may also extend along the length direction of the square side of the insulating ring where the protrusion is located, and is connected with the top surface at positions of two ends along the length direction of the square side.

The insulating ring 1 may be a ceramic ring, for example, of the material may be aluminum oxide, and the insulating ring 1 may also be a plastic ring. The insulating ring 1 may be processed by stamping, so that the insulating ring of the embodiment may be fabricated as along as a stamping die is modified, thereby causing less impact on the cost of production.

The pin 4 is disposed on the side surface and attached to the outer sidewall that is above the side surface. The pin 4 includes the surface metallization layer, the adhesive material layer, a pin layer and the protective layer that wraps the exposed portions of the surface metallization layer, the adhesive material layer and the pin layer (referring to FIG. 8). The adhesive material layer made of CuAg alloy is generally 15 to 20 µm in thickness, the surface metallization layer (the material thereof may be W) between the adhesive material layer and the insulating ring 1 is generally 15 to 20 µm in thickness, the pin layer (the material thereof may be FeNi alloy) is generally about 100 µm in thickness, and an upper surface of the pin layer is basically at the same level as the top surface, therefore, a distance between the side surface and the top surface is 130 to 140 µm, and the insulating ring 1 is generally greater than 200 µm in height.

Then, the protective layer is electroplated at the exposed portions of the surface metallization layer, the adhesive material layer and the pin layer and the top surface adjacent to the pin. The protective layer may be made of NiCo alloy with good conductivity and is generally less than 3 µm in thickness.

The material of the seal cap 3 may be ceramic, plastic or metal, and so on. The material of the conductive flange 2 may be copper, and so on.

For the package of the embodiment, because the side surface of an adopted insulating ring where the pin is disposed is lower than the top surface, and the adhesive material layer and the surface metallization layer in the pin are lower than the top surface, the adhesive material after creeping also cannot be higher than the top surface. During the process of using a device, silver ions have no components of an electric field in a horizontal direction, and lateral migration is blocked by the outer sidewall that is above the side surface. The electric field directs to the side surface in a vertical direction and is opposite to the migration path of the silver ions. Therefore, the silver ions cannot pass around the outer sidewall and the top surface above the side surface to enter the package, and accordingly, the top surface and the bottom surface of the insulating ring cannot be electrically connected, thereby ensuring the reliability of a PA device.

Besides the PA device, the package may also be used for the packaging of PCBs of other chips and hybrid chips, and so on. In addition to ceramic packaging, the foregoing package is also applicable to plastic packaging and hybrid module packaging, and so on.

It should be noted that the relational terms here such as first and second are used to differentiate an entity or operation from another entity or operation, and do not require or imply any actual relationship or sequence between these entities or operations. Moreover, the terms "include", "comprise", and any variation thereof are intended to cover a non-exclusive inclusion. Therefore, a process, method, object, or device, which includes a series of elements, not only includes such elements, but also includes other elements not specified expressly, or may further include inherent elements of the process, method, object, or device. If no more limitations are made, an element limited by "include a/an..." does not exclude other same elements existing in the process, the method, the article, or the device which includes the element.

The above are merely provided as exemplary embodiments of the present invention, but not intended to limit the protection scope of the present invention. Any modification, equivalent replacement, and improvement made within the spirit and principle of the present invention all fall within the protection scope of the present invention.

## Claims

1. An insulating ring for packaging, wherein a through hole of the insulating ring drills through a top surface and a bottom surface of the insulating ring, to accommodate a chip;
an outer sidewall of the insulating ring has an outward extending protrusion at a position where a pin is connected, a side surface of the protrusion facing the top surface is lower than the top surface, the pin is disposed on the side surface, and an adhesive material layer and a surface metallization layer in the pin are lower than the top surface.

2. The insulating ring according to claim 1, wherein the insulating ring is a square insulating ring.

3. The insulating ring according to claim 2, wherein the protrusion extends to two ends of a square side where the protrusion is located along a length direction of the square side.

4. The insulating ring according to claim 2, wherein the protrusion extends along a length direction of a square side where the protrusion is located, and a length of the protrusion along the length direction of the square side where the protrusion is located is less than a length of the square side.

5. The insulating ring according to claim 2, wherein the protrusion extends along a length direction of a square side where the protrusion is located, and the protrusion is connected with the top surface at positions of two ends along the length direction of the square side where the protrusion is located.

6. The insulating ring according to any one of claims 1 to 5, wherein a material of the insulating ring is aluminum oxide.

7. The insulating ring according to any one of claims 1 to 5, wherein a distance between the side surface and the top surface is 130 to 140 µm.

8. The insulating ring according to claim 7, wherein the insulating ring is greater than 200 µm in height.

9. An insulating ring assembly, comprising an insulating ring and a pin which is connected to the insulating ring, wherein a through hole of the insulating ring drills through a top surface and a bottom surface of the insulating ring, to accommodate a chip;
an outer sidewall of the insulating ring has an outward extending protrusion at a position where the pin is connected, a side surface of the protrusion which faces the top surface is lower than the top surface, the pin is disposed on the side surface, and an adhesive material layer and a surface metallization layer in the pin are lower than the top surface; and exposed portions of each of other layers in the pin and the top surface adjacent to the pin are wrapped by a protective layer in the pin.

10. The insulating ring assembly according to claim 9, wherein the insulating ring is a square insulating ring.

11. The insulating ring assembly according to claim 10, wherein the protrusion extends to two ends of a square side where the protrusion is located along a length direction of the square side.

12. The insulating ring assembly according to claim 10, wherein the protrusion extends along a length direction of a square side where the protrusion is located, and a length of the protrusion along the length direction of the square side where the protrusion is located is less than a length of the square side.

13. The insulating ring assembly according to claim 10, wherein the protrusion extends along a length direction of a square side where the protrusion is located, and the protrusion is connected with the top surface at positions of two ends along the length direction of the square side where the protrusion is located.

14. A package, comprising a conductive flange, an insulating ring fixed on the conductive flange, a pin connected to the insulating ring and a seal cap covering the insulating ring, wherein a through hole of the insulating ring drills through a top surface and a bottom surface of the insulating ring, and a space is formed by the through hole, the conductive flange and the seal cap to accommodate a chip;
an outer sidewall of the insulating ring has an outward extending protrusion at a position where the pin is connected, a side surface of the protrusion facing the top surface is lower than the top surface, the pin is disposed on the side surface, and an adhesive material layer and a surface metallization layer in the pin are lower than the top surface; and exposed portions of each of other layers in the pin and the top surface adjacent to the pin are wrapped by a protective layer in the pin.

15. The package according to claim 14, wherein the insulating ring is a square insulating ring.

16. The package according to claim 15, wherein the protrusion extends to two ends of a square side of the insulating ring where the protrusion is located along a length direction of the square side.

17. The package according to claim 15, wherein the protrusion extends along a length direction of a square side of the insulating ring where the protrusion is located, and a length of the protrusion along the length direction of the square side is less than a length of the square side.

18. The package according to claim 15, wherein the protrusion extends along a length direction of a square side of the insulating ring where the protrusion is located, and the protrusion is connected with the top surface at positions of two ends along the length direction of the square side.
